# FASCICULE DE BREVET EUROPEEN

(11) **EP 4 718 096 B1**
(45) Date de publication et mention de la délivrance du brevet: **02.12.2026**
(21) Numéro de dépôt: 25204055.5
(22) Date de dépôt: 23.09.2025
(51) Int. Cl.: G01R 31/382, G01K 7/24, H01M 10/48

(54) **PROCÉDÉ ET SYSTÈME DE MESURE PHYSIQUE AU COEUR D'UN ACCUMULATEUR ÉLECTROCHIMIQUE**
VERFAHREN UND SYSTEM ZUR PHYSIKALISCHEN MESSUNG AM KERN EINES ELEKTROCHEMISCHEN AKKUMULATORS
METHOD AND SYSTEM FOR PHYSICAL MEASUREMENT AT THE CORE OF AN ELECTROCHEMICAL ACCUMULATOR

(30) Priorité: 25.09.2024 FR 2410229
(43) Date de publication de la demande: 01.04.2026
(73) Titulaire: Commissariat à l'Energie Atomique et aux Energies Alternatives, 75015 Paris (FR)
(72) Inventeur: RANIERI, Marco, 38054 Grenoble Cedex 9 (FR); CHAUVIN, Julien, 38054 Grenoble Cedex 9 (FR); BRUN-BUISSON, David, 38054 Grenoble Cedex 9 (FR); SERRA, Lionel, 38054 Grenoble Cedex 9 (FR)
(74) Mandataire: Lavoix

(56) Documents cités:
- CN-A- 118 348 429
- DE-A1- 10 258 845
- DE-A1- 102017 215 144
- US-A1- 2019 305 387

## Description

La présente invention concerne un système de mesure physique au coeur d'un accumulateur électrochimique présentant deux bornes de puissance distinctes.

La présente invention concerne également un procédé de mesure physique au coeur d'un accumulateur électrochimique présentant deux bornes de puissance distinctes.

L'invention se situe dans le domaine de la gestion de batteries et plus précisément celui des accumulateurs électrochimiques, tels que les accumulateurs électrochimiques Li-ion, les accumulateurs électrochimiques NiMH, les accumulateurs électrochimiques Pb, etc.

Plus précisément, la présente invention porte sur le contrôle d'au moins une grandeur physique interne d'un accumulateur électrochimique (i.e. également appelée cellule électrochimique), ladite grandeur physique interne correspondant par exemple à la température interne de l'accumulateur électrochimique considéré, à sa pression interne, à une déformation en surface, un étirement, l'état de charge, la concentration de ions Li+ (i.e. ions Lithium+), etc.

Actuellement, il existe déjà des solutions ayant pour objectif de collecter de l'information sur l'état interne d'une batterie correspondant à un ensemble d'accumulateurs électrochimiques, chaque accumulateur électrochimique présentant par nature deux bornes de puissances (i.e. électrodes) distinctes.

Par exemple, une première solution est basée sur la mesure de l'impédance interne de l'accumulateur électrochimique considéré, mais une telle mesure nécessite une mesure à quatre fils par accumulateur électrochimique ce qui est trop couteux à implémenter dans un pack de batterie comprenant une pluralité d'accumulateurs électrochimiques.

En effet, l'ajout de chacune des deux bornes de puissances (i.e. de électrodes) nécessaires pour faire une mesure à quatre fils, en sus des deux bornes de puissances (i.e. électrodes) propres à l'accumulateur électrochimique, est une source de coût supplémentaire, car cela nécessite non seulement du travail et/ou du développement pour garantir l'étanchéité de l'accumulateur électrochimique (i.e. la cellule électrochimique) autour de la borne de puissance (i.e. l'électrode) ajoutée, mais aussi le déploiement de connexions (i.e. fils) spécialement dédiées à la mesure entre la cellule et le système de gestion de batterie BMS (de l'anglais *Battery Management System*).

Une deuxième solution porte sur l'insertion de fibres optiques dans la partie active de chaque accumulateur électrochimique mais cette deuxième solution nécessite d'avoir un système d'optique couteux, un collimateur et un analyseur de spectre pour extraire de l'information utile. De plus, cette instrumentation est intrusive au niveau de l'architecture (i.e. de l'enveloppe) de l'accumulateur électrochimique, ce qui engendre des problèmes supplémentaires tels que la gestion des fuites et la gestion de la corrosion associée.

D'autres solutions sont dites de type « Cellule intelligente» (i.e. de l'anglais *smart cell*), à savoir basées sur l'introduction d'un microcontrôleur relativement puissant dans chaque accumulateur électrochimique (i.e. cellule électrochimique), et requérant l'établissement d'un canal de communication numérique entre l'accumulateur électrochimique considéré et l'extérieur, ce canal de communication étant filaire, capacitif, optique, par courant porteur, etc., ce qui est également complexe et onéreux à mettre en œuvre.

US2019/305387A1 divulgue un capteur de température arrangé à l'intérieur d'une batterie. Le capteur de température comprend un condensateur et une inductance formant un circuit résonant. Une température de la batterie est estimée à partir de la fréquence de résonance du circuit résonant.

Autrement dit, les solutions existantes sont peu réalistes d'un point de vue techno-économique.

Le but de l'invention est alors de proposer une solution permettant de minimiser impact et coûts du contrôle d'au moins une grandeur physique interne d'un accumulateur électrochimique.

A cet effet, l'invention a pour objet un système de mesure physique au cœur d'un accumulateur électrochimique présentant deux bornes de puissance distinctes, ledit système comprenant au moins :
- au moins un capteur résistif introduit à l'intérieur dudit accumulateur électrochimique, et connecté via une de ses extrémités à une desdites deux bornes de puissance distinctes, l'autre extrémité dudit capteur résistif étant connectée, via un élément électrique de blocage de courant continu, à l'autre desdites deux bornes de puissance distinctes ;
- un ensemble d'éléments électriques externes audit accumulateur électrochimique, ledit ensemble étant connecté via chacune de ses deux extrémités à chacune desdites deux bornes de puissance distinctes de sorte à former, avec ledit au moins un capteur résistif, au moins un circuit électrique résonant propre à résonner à une fréquence fixe prédéterminée ;
- un module de mesure, externe audit accumulateur électrochimique, configuré pour :
   - exciter ledit au moins un circuit électrique résonant en pilotant une génération de tension d'alimentation, au niveau desdites deux bornes de puissance distinctes, sur au moins une plage de fréquence centrée sur ladite fréquence fixe prédéterminée;
   - mesurer au moins une information représentative de la forme du pic de résonance résultant ;
- obtenir une valeur d'au moins une grandeur physique interne dudit accumulateur électrochimique à partir de ladite au moins une information représentative mesurée.

Ainsi, la présente invention propose de définir un nouveau type de capteurs permettant une intégration aisée au sein des accumulateurs électrochimiques. L'intégration de ce type de capteur est propre à être appliquée dès la conception de l'accumulateur électrochimique ou ultérieurement.

Avantageusement, la présente invention évite d'ajouter une borne de puissance (i.e. électrode) à l'accumulateur électrochimique, à part les bornes de puissances (i.e. électrodes) positive et négative déjà présentes.

Ainsi, la présente invention permet, en insérant, au sein de l'accumulateur électrochimique, un outil de diagnostic tel que le capteur résistif proposé, dont la valeur de résistance varie en fonction de la grandeur physique interne à mesurer, de réaliser passivement du fait du comportement résistif passif assimilable à celui d'une résistance, des contrôles non destructifs qui ne perturberont pas le bon fonctionnement électrochimique tout en ne modifiant pas l'agencement des bornes de puissances (i.e. électrodes) des éléments de batteries (i.e. accumulateurs électrochimiques) actuellement développés.

A noter que l'introduction d'un tel capteur résistif à l'intérieur de l'accumulateur électrochimique est nécessairement associée à l'introduction d'un élément électrique de blocage de courant continu (de l'anglais *DCstop*) pour ne pas laisser le courant continu et protéger les deux bornes de puissance dudit accumulateur électrochimique contre tout court-circuit. Un tel élément étant par exemple un condensateur ajouté en série avec ledit capteur résistif à l'intérieur dudit accumulateur électrochimique.

Ainsi la présente invention répond à la nécessité d'être au plus proche d'une réalisation à l'échelle industrielle.

Suivant d'autres aspects avantageux de l'invention, le système de mesure physique au coeur d'un accumulateur électrochimique comprend une ou plusieurs des caractéristiques suivantes, prises isolément ou suivant toutes les combinaisons techniquement possibles :
- ledit ensemble d'éléments électriques externes audit accumulateur électrochimique comprend au moins une inductance et au moins un condensateur de sorte à former en série, avec ledit au moins un capteur résistif, ledit au moins un circuit électrique résonant ;
- ladite au moins une information représentative appartient au groupe comprenant :
   - une amplitude dudit pic de résonance résultant ;
   - un facteur de qualité dudit pic de résonance résultant ;
- ledit au moins un capteur résistif et chaque élément électrique dudit ensemble d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique est maximale ;
- le système comprend en outre, à l'intérieur dudit accumulateur électrochimique, un ensemble d'éléments de filtrage limitant la perturbation due à l'impédance interne propre uniquement audit accumulateur électrochimique et/ou due à la présence d'au moins un équipement externe connecté audit accumulateur électrochimique ;
- ledit ensemble d'éléments de filtrage comprend quatre éléments inductifs insérés en série entre lesdites deux bornes de puissance distinctes dudit accumulateur électrochimique.
- la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système ;
- ledit système comprend au moins deux capteurs résistifs distincts de sorte à former avec ledit ensemble d'éléments électriques externes audit accumulateur électrochimique au moins deux circuits électriques résonants distincts propres à résonner à au moins deux fréquences fixes prédéterminées distinctes, ledit module de mesure, externe audit accumulateur électrochimique, étant configuré pour :
   - exciter ledit au moins un circuit électrique résonant en pilotant une génération de tension d'alimentation, au niveau desdites deux bornes de puissance distinctes, sur au moins deux plages de fréquence distinctes centrées respectivement sur lesdites au moins deux fréquences fixes prédéterminées distinctes;
   - mesurer une information représentative de la forme de chaque pic de résonance résultant ;
   - obtenir une valeur d'au moins une grandeur physique interne dudit accumulateur électrochimique à partir de chaque information représentative mesurée ;
- chaque plage de fréquence d'excitation est étroite et définie à -3 dB de l'amplitude du pic de résonance associée à chaque fréquence fixe prédéterminée ;
- ledit au moins un capteur résistif est au moins un élément appartenant au groupe comprenant au moins :
   - un ensemble comprenant au moins une résistance de type CTN à coefficient de température négatif ;
   - un ensemble comprenant au moins une résistance de type CTP à coefficient de température positif ;
   - une jauge de déformation ;
   - un capteur de pression résistif ;
- ledit ensemble d'éléments électriques externes audit accumulateur électrochimique est déconnectable/reconnectable auxdites deux bornes de puissance distinctes.

L'invention concerne également un procédé de mesure physique au coeur d'un accumulateur électrochimique présentant deux bornes de puissance distinctes, comprenant au moins les étapes suivantes :
- introduction d'au moins un capteur résistif à l'intérieur dudit accumulateur électrochimique, ledit au moins un capteur résistif étant connecté via une de ses extrémités à une desdites deux bornes de puissance distinctes, l'autre extrémité dudit capteur résistif étant connectée, via un élément électrique de blocage de courant continu, à l'autre desdites deux bornes de puissance distinctes ;
- connexion d'un ensemble d'éléments électriques externes audit accumulateur électrochimique, via chacune de ses deux extrémités à chacune desdites deux bornes de puissance distinctes, de sorte à former, avec ledit au moins un capteur résistif, au moins un circuit électrique résonant propre à résonner à une fréquence fixe prédéterminée;
- excitation dudit au moins un circuit électrique résonant en pilotant une génération de tension d'alimentation, au niveau desdites deux bornes de puissance distinctes, sur au moins une plage de fréquence centrée sur ladite fréquence fixe prédéterminée;
- mesure d'au moins une information représentative de la forme du pic de résonance résultant ;
- obtention d'une valeur d'au moins une grandeur physique interne dudit accumulateur électrochimique à partir de ladite au moins une information représentative mesurée.

Suivant un autre aspect avantageux de l'invention, le procédé de mesure physique au cœur d'un accumulateur électrochimique comprend en outre l'introduction à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

L'invention apparaîtra plus clairement à la lecture de la description qui va suivre, donnée uniquement à titre d'exemple non limitatif, et faite en référence aux dessins dans lesquels :
[Fig. 1] la figure 1 est une représentation schématique d'un système de mesure physique au coeur d'un accumulateur électrochimique selon la présente invention.
[Fig. 2] la figure 2 est une représentation schématique d'un exemple de circuit équivalent au système de mesure physique au cœur d'un accumulateur électrochimique, selon la présente invention.
[Fig. 3] la figure 3 est un organigramme des principales étapes d'un procédé de mesure physique au cœur d'un accumulateur électrochimique selon la présente invention.

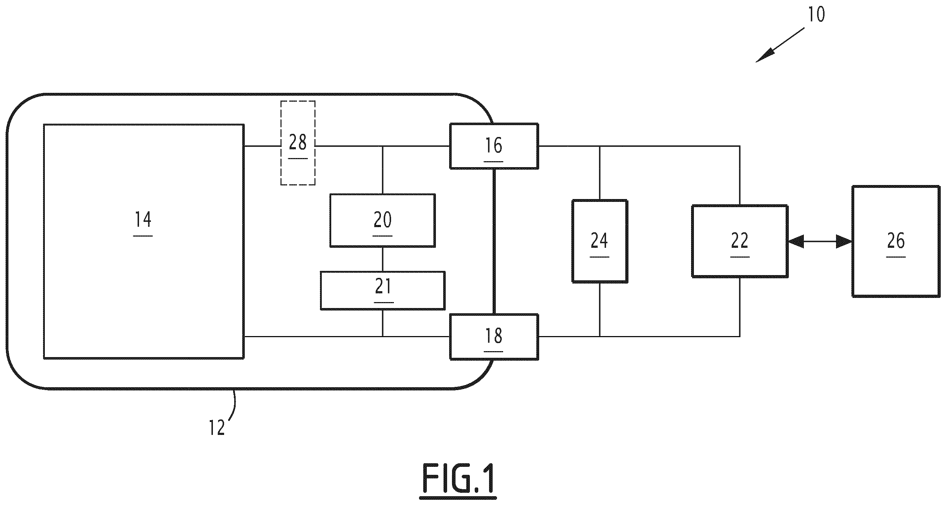

La figure 1 illustre un mode de réalisation d'un système 10 de mesure physique au cœur d'un accumulateur électrochimique 12. Sur la figure 1, ledit accumulateur électrochimique 12 comprend, en son enveloppe, une partie active 14 et présente deux bornes de puissance distinctes (i.e. deux électrodes distinctes) 16 et 18.

Selon la présente invention, le système 10 de mesure physique au cœur de l'accumulateur électrochimique 12 comprend en outre au moins un capteur résistif 20 propre à être mis en place (i.e. introduit) à l'intérieur dudit accumulateur électrochimique 12 (i.e. à l'intérieur de son enveloppe, de son boitier), notamment lors de la fabrication dudit accumulateur électrochimique 12, et connecté via une de ses extrémités à une desdites deux bornes de puissance distinctes, l'autre extrémité dudit capteur résistif étant connectée, via un élément 21 électrique de blocage de courant continu, à l'autre desdites deux bornes de puissance distinctes. Autrement dit, selon un exemple, on construit directement l'accumulateur électrochimique 12 avec le capteur résistif 20 à l'intérieur.

A noter que l'introduction d'un tel capteur résistif 20 à l'intérieur de l'accumulateur électrochimique est nécessairement associée à l'introduction de l'élément 21 électrique de blocage de courant continu (de l'anglais *DCstop*) pour ne pas laisser le courant continu et protéger les deux bornes de puissance dudit accumulateur électrochimique contre tout court-circuit. Un tel élément 21 étant par exemple un condensateur ajouté en série avec ledit capteur résistif 20 à l'intérieur dudit accumulateur électrochimique 12.

De plus, ledit système de mesure 10 comprend également un ensemble 22 d'éléments électriques externes audit accumulateur électrochimique 12 (i.e. en dehors de son enveloppe, c'est-à-dire de son boitier), ledit ensemble 22 étant connecté, en parallèle tel qu'illustré par la figure 1, via chacune de ses deux extrémités à chacune desdites deux bornes de puissance distinctes 16 et 18 de sorte à former, avec ledit au moins un capteur résistif 20, au moins un circuit électrique résonant propre à résonner à une fréquence fixe prédéterminée.

Comme illustré également par la figure 1, classiquement, une charge 24 est placée également en parallèle desdites deux bornes de puissance distinctes 16 et 18.

Le système de mesure 10 comprend en outre, selon la présente invention, un module de mesure 26, externe audit accumulateur électrochimique. Un tel module de mesure 26 est tout d'abord propre à exciter ledit au moins un circuit électrique résonant, en pilotant une génération de tension d'alimentation, au niveau desdites deux bornes de puissance distinctes 16 et 18, sur au moins une plage de fréquence centrée sur ladite fréquence fixe prédéterminée.

De plus, le module de mesure 26 est également propre à mesurer au moins une information représentative de la forme du pic de résonance résultant.

Le module de mesure 26 est en outre propre à obtenir une valeur d'au moins une grandeur physique interne dudit accumulateur électrochimique 12 à partir de ladite au moins une information représentative mesurée. Autrement dit, l'information utile pour la mesure de la grandeur physique interne souhaitée s'étudie en fréquence, la fréquence de résonance mesurée étant représentative de la grandeur physique interne associée au sein de l'accumulateur électrochimique 12. Par exemple, une table déterminée au préalable permet d'associer la valeur de fréquence de résonance mesurée à une valeur de ladite grandeur physique interne.

Ainsi, le système de mesure 10, selon la présente invention, utilise la capacité d'auto-résonance dudit au moins un circuit électrique résonant formé d'une part par ledit au moins un capteur résistif 20 interne à l'accumulateur électrochimique 12 et d'autre part par un ensemble 22 d'éléments électriques externes audit accumulateur électrochimique 12.

Pour ce faire, ledit au moins un capteur résistif 20 implémenté, dudit au moins un circuit électrique résonant, est adressé (i.e. « interrogé ») en fréquence via ledit module de mesure 26 et non en courant continu, et est uniquement connecté entre les deux bornes de puissance 16 et 18 (i.e. électrodes de puissance), respectivement positive et négative, naturellement présentes pour connecter l'accumulateur électrochimique 12 (i.e. de la cellule électrochimique), ce qui évite toute borne de puissance additionnelle (i.e. d'électrode supplémentaire).

Ainsi, selon la présente invention, il est proposé d'utiliser un ou plusieurs capteurs résistif(s) à l'intérieur de l'accumulateur électrochimique (i.e. de la cellule électrochimique), dont l'information utile s'étudie en fréquence, et faisant partie d'un circuit resonnant dont le reste 22 des composants se trouve à l'extérieur de la cellule, même à une distance considérable, comme par exemple sur le circuit imprimé (i.e. la carte PCB (de l'anglais printed circuit board) du système de gestion de batterie BMS (de l'anglais *Battery Management System*) du module de la batterie. Ledit au moins un capteur résistif, en variant sa valeur « électronique », c'est-à-dire sa valeur de résistance en fonction de la grandeur physique interne en jeu, notamment la température de son environnement, est ainsi propre à donner une information sur ce qui se passe à l'intérieur de l'accumulateur électrochimique (i.e. de la cellule électrochimique).

Le fait de pouvoir interroger à distance le capteur résistif 20, et sans connectiques additionnelles, constitue un avantage considérable du point de vue d'une possible industrialisation, car cela laisse libre le constructeur de choisir l'emplacement du circuit résonant (i.e. notamment de ces éléments externes) selon ce qui est le plus avantageux pour lui.

En complément facultatif, ladite au moins une information représentative appartient au groupe comprenant :
- une amplitude dudit pic de résonnance résultant ;
- un facteur de qualité dudit pic de résonnance résultant.

En complément facultatif, ledit ensemble 22 d'éléments électriques externes audit accumulateur électrochimique est déconnectable/reconnectable auxdites deux bornes de puissance distinctes 16 et 18. Autrement dit, selon ce complément facultatif, il est également envisageable de n'implémenter qu'un seul circuit résonant, dont la connexion aux différents éléments de la batterie, à savoir les différents accumulateurs électrochimiques de la batterie, est aiguillée par multiplexage.

En outre, il est à noter que la nature résistive du capteur 20 requiert d'ajouter un système de blocage du courant continu contre les court-circuits propres à endommager les deux bornes de puissance 16 et 18 (i.e. électrodes) de de l'accumulateur électrochimique (i.e. de la cellule électrochimique).

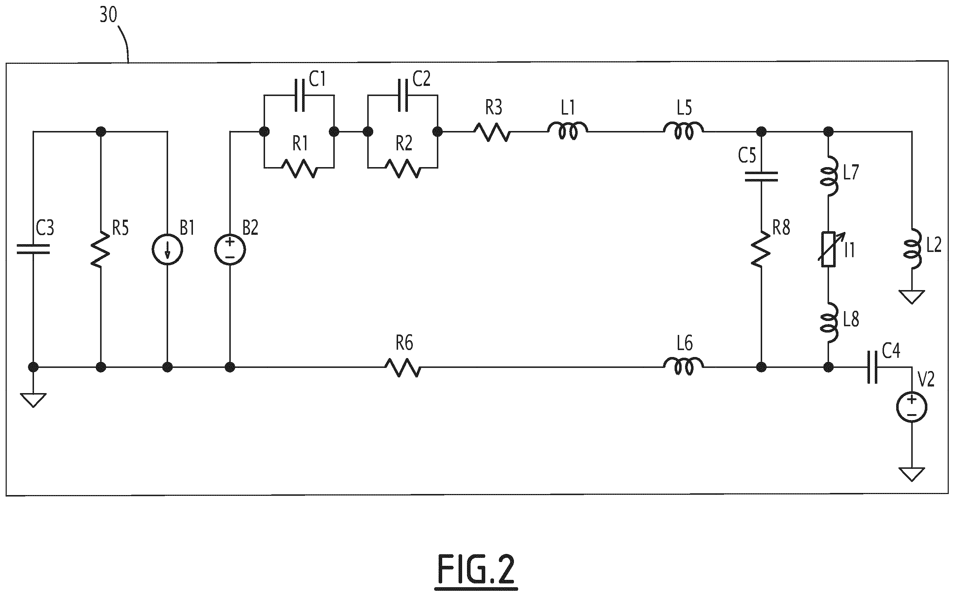

En complément facultatif, tel qu'illustré par la suite par la figure 2, ledit ensemble 22 d'éléments électriques externes audit accumulateur électrochimique 12 comprend au moins une inductance et au moins un condensateur de sorte à former en série, avec ledit au moins un capteur résistif, ledit au moins un circuit électrique résonant.

Selon une première variante, ledit au moins un capteur résistif 20 et chaque élément électrique dudit ensemble 22 d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique 12 est maximale.

Une telle première variante est intéressante, car si l'impédance résultante dudit accumulateur électrochimique 12 (i.e. l'impédance globale de l'accumulateur électrochimique après connexion aux éléments 20 et 22 de la présente invention) est élevée dans une plage de fréquences précises, et supérieure de plusieurs ordres de grandeurs par rapport à l'impédance interne propre uniquement audit accumulateur électrochimique 12 à régime continu, alors le signal du résonateur (i.e. du circuit résonant) est propre à être naturellement peu atténué par l'impédance interne propre uniquement audit accumulateur électrochimique 12 (i.e. l'impédance naturelle de la cellule électrochimique 12 sans connexion aux éléments 20 et 22 de la présente invention), et reste exploitable en permanence, sans nécessiter l'ajout d'éléments de filtrage dédiés à protéger, le signal utile du résonateur, de la perturbation due à l'impédance naturelle de l'accumulateur électrochimique lui-même et/ou due à l'éventuelle présence d'un équipement externe connecté à l'accumulateur électrochimique, tel qu'un moteur, un chargeur, etc...

A titre d'alternative à la première variante, selon une deuxième variante, tel qu'illustré en pointillés sur la figure 1 et représenté en détail sur la figure 2 décrite par la suite, le système 10 de mesure physique selon la présente invention, comprend en outre optionnellement, à l'intérieur dudit accumulateur électrochimique 12, un ensemble 28 d'éléments de filtrage limitant la perturbation due à l'impédance interne propre uniquement audit accumulateur électrochimique et/ou due à la présence d'au moins un équipement externe connecté audit accumulateur électrochimique 12.

En complément facultatif de cette deuxième variante, tel qu'illustré par la suite par la figure 2, ledit ensemble 28 d'éléments de filtrage comprend quatre éléments inductifs insérés en série entre lesdites deux bornes de puissance distinctes 16 et 18 dudit accumulateur électrochimique 12.

En option pour ce complément facultatif, la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système.

Selon un autre complément facultatif, ledit système 10 comprend au moins deux capteurs résistifs distincts de sorte à former avec ledit ensemble d'éléments électriques externes audit accumulateur électrochimique au moins deux circuits électriques résonants distincts propres à résonner à au moins deux fréquences fixes prédéterminées distinctes, ledit module de mesure, externe audit accumulateur électrochimique, étant configuré pour :
- exciter ledit au moins un circuit électrique résonant en pilotant une génération de tension d'alimentation, au niveau desdites deux bornes de puissance distinctes, sur au moins deux plages de fréquence distinctes centrées respectivement sur lesdites au moins deux fréquences fixes prédéterminées distinctes;
- mesurer une information représentative de la forme de chaque pic de résonnance résultant ;
- obtenir une valeur d'au moins une grandeur physique interne dudit accumulateur électrochimique à partir de chaque information représentative mesurée.

En effet, sachant qu'un objet électronique peut présenter plusieurs fréquences de résonance, avec un choix astucieux de capteurs/composants, selon ce complément facultatif il est proposé d'introduire plusieurs capteurs résistifs différents à l'intérieur de l'accumulateur électrochimique, par exemple un qui présente une fréquence de résonance fixe à 10 kHz et l'autre à 100 kHz, rendant possible le discernement de l'origine (i.e. de la grandeur physique interne) associée au signal mesuré et donc d'obtenir deux grandeurs physiques internes distinctes, tel que par exemple la température et l'état de charge dudit accumulateur électrochimique.

En complément facultatif, chaque plage de fréquence d'excitation est étroite et définie à -3 dB de l'amplitude du pic de résonnance associée à chaque fréquence fixe prédéterminée.

Selon un autre complément facultatif, ledit au moins un capteur résistif est au moins un élément appartenant au groupe comprenant au moins :
- un ensemble comprenant au moins une résistance de type CTN à coefficient de température négatif ;
- un ensemble comprenant au moins une résistance de type CTP à coefficient de température positif ;
- une jauge de déformation ;
- un capteur de pression résistif.

Une résistance simple de type CTN (ou une combinaison de résistances de type CTN) ou une résistance simple de type CTP (ou une combinaison de résistances de type CTP) est propre, lorsqu'elle rentre en résonance avec le reste des éléments externes de l'ensemble 22, à fournir un pic de résonance dont la forme en amplitude ou en facteur de qualité est associée à une valeur prédéterminée de température.

En particulier, une résistance simple de type CTN (également appelée thermistance) est un composant dont la résistance augmente si sa température diminue. A noter qu'il existe dans le commerce plein de composants de ce type, tel que à titre d'exemple illustratif la résistance de type CTN NTCLE203E3104GB0 de Vishay^{©}, avec des valeurs de résistance nominale à 25°C très différents entre eux, si bien que chaque choix de capteur résistif nécessite en conséquence un redimensionnement des autres éléments constitutifs du système de mesure selon la présente invention.

La jauge de déformation résistive est quant à elle propre, lorsqu'elle rentre en résonance avec le reste des éléments externes de l'ensemble 22, à fournir un pic de résonance dont la forme en amplitude ou en facteur de qualité est associée à une valeur prédéterminée de déformation en surface, d'étirement au sein de (i.e. au coeur de) l'accumulateur électrochimique considéré.

Le capteur de pression résistif est quant à lui propre, lorsqu'il rentre en résonance avec le reste des éléments externes de l'ensemble 22, à fournir un pic de résonance dont la forme en amplitude ou en facteur de qualité est associée à une valeur prédéterminée de pression au sein de (i.e. au coeur de) l'accumulateur électrochimique considéré.

La figure 2 est une représentation schématique d'un exemple de circuit équivalent 30 au système de mesure physique au coeur d'un accumulateur électrochimique, selon la présente invention.

En effet, pour valider l'approche selon la présente invention, des simulations ont été réalisées en utilisant un circuit équivalent.

Selon l'exemple de la figure 2, l'accumulateur électrochimique correspond notamment à une cellule Li-ion générique représentée par un circuit selon un « modèle RC » d'une batterie ayant une capacité de 3 à 5 Ampères-heure (i.e. 3,5 à 5Ah), composée par les éléments capacitifs : C1, C2, C3, résistifs : R1, R2, R3, R5, R6, inductifs : L1 et les générateurs de courant ou de tension B1, B2 et I1.

Par exemple, pour une cellule Li-ion générique d'une batterie ayant une capacité de 3 à 5 Ampères-heure, on considère les valeurs suivantes : C1=1000pF, C2=10µF C3=18000F, R1=0,1Ω, R2=0,1Ω, R3=0,1Ω, R5=10kΩ, R6=1mΩ, L1=1nH. En simulation, le comportement d'un circuit formé des seuls éléments précités a été simulé afin de vérifier que son comportement est cohérent notamment avec celui d'un accumulateur électrochimique de capacité d'environ 3,5Ah qui se décharge avec un ampère de courant constant. Il est à noter que les valeurs précitées sont indicatives et non restrictives, car utilisées en simulation sans forcément avoir de contrepartie physique directe.

Selon la présente invention, le circuit équivalent 30 comprend en outre spécifiquement les éléments du systèmes de mesure physique proposé à savoir ledit au moins capteur résistif introduit à l'intérieur dudit accumulateur électrochimique et représentés sur l'exemple de la figure 2 par la résistance R8, ladite résistance R8 étant par ailleurs connectée à l'élément électrique de blocage de courant continu représenté par le condensateur C5 par exemple de valeur égale à 1µF, et l'ensemble d'éléments électriques (i.e. de composants) externes audit accumulateur électrochimique correspondant représentés sur l'exemple de la figure 2 par l'inductance L2, telle que par exemple L2=10µH, et le condensateur C4, telle que par exemple C4=3,185µF.

Avec ladite résistance R8 à l'intérieur de l'accumulateur électrochimique, les composants L2 et C4 externes audit accumulateur électrochimique forment, une fois connectés aux bornes de puissances dudit accumulateur électrochimique, le circuit résonateur dont l'information représentative de la forme du pic de résonnance est représentative de la grandeur physique interne à mesurer au coeur de l'accumulateur électrochimique.

A noter que la similation d'un tel cicruit équivalent 30 avec ladite résistance R8 variant entre 1 et 100Ω par pas de 10Ω (ces valeurs étant représentatives de ce qu'on pourrait attendre un utilisant une résistance soumise à une variation de température comparable à ce qui peut se passer au coeur d'une cellule Li-ion), présente une fréquence de résonance ${f}_{0} = \frac{1}{2 π \sqrt{LC}}$ de 28,2kHz stable indépendamment de la valeur de la résistance, mais qu'en fonction de la valeur de résistance, c'est la forme du pic de résonance qui varie en amplitude ou en facteur de qualité Q tel que $Q = \frac{1}{R} \sqrt{\frac{L}{C}} .$, et selon la présente invention cette forme est utilisée comme l'indicateur de la grandeur physique interne à mesurer, telle que la température, pour un résistance simple de type NTC ou PTC.

A noter que plus la valeur du facteur de qualité Q est élevée, plus la bande de fréquence utilisée pour l'excitation du circuit RLC est étroite, et notamment définie à -3 dB de l'amplitude du pic (autrement dit : plus Q est grand, plus le pic est accentué).

L'exemple de la figure 2 correspond en particulier à la deuxième variante précédemment citée où le système de mesure physique selon la présente invention, comprend en outre optionnellement, à l'intérieur dudit accumulateur électrochimique, un ensemble d'éléments de filtrage limitant la perturbation due à l'impédance interne propre uniquement audit accumulateur électrochimique et/ou due à la présence d'au moins un équipement externe connecté audit accumulateur électrochimique. Cet ensemble d'éléments de filtrage, référencé 28 dans la figure 1, correspond dans le circuit équivalent 30 de la figure 2 aux inductances L5, L6, L7 et L8 en série avec les bornes de puissances distinctes de l'accumulateur électrochimique et vise à s'affranchir d'une perturbation qui se rapproche d'un courant continu. Selon l'exemple de la figure 2, la valeur de ces quatre inductances est par exemple de 100mH.

A noter que les inductances L5, L6, L7 et L8 ajoutées à titre de protection pour ne pas subir les perturbations dues à l'impédance propre de l'accumulateur électrochimique et/ou dues à ce qui y est connecté à l'extérieur requiert un dimensionnement selon lequel la valeur de chacun desdits éléments de filtrage inductifs L5, L6, L7 et L8 est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système de mesure selon la présente invention (i.e. sans les éléments C4, C5, R8, L2, L5, L6, L7, L8 et V2).

A noter que la définition de « dynamique initiale » dépend de l'application. Par exemple, une accélération brutale d'un véhicule électrique demande un courant important en quelques dizaines de millisecondes, alors qu'une recharge de batterie ne demande que des profils lents.

Un tel dimensionnement revient, en pratique, à chercher un temps de montée du courant dans l'accumulateur électrochimique au maximum dix fois supérieur au temps initial lorsque que ledit accumulateur électrochimique est déconnecté dudit système de mesure selon la présente invention (i.e. sans les éléments C4, C5, R8, L2, L5, L6, L7, L8 et V2), en considérant qu'on entend par « temps initial » le temps que le courant aurait mis à s'instaurer en l'absence des éléments L2, C4 et R8.

Autrement dit, le bon dimensionnement de l'ensemble des éléments de filtrage L5, L6, L7 et L8 est défini en se plaçant d'un point de vue « dynamique » de l'accumulateur électrochimique face à un appel de courant, afin de prendre en compte le besoin de ne pas dégrader les spécifications électriques de l'accumulateur électrochimique (i.e. de la cellule électrochimique), à savoir laisser passer le courant qui rentre ou qui sort de l'accumulateur électrochimique par le circuit de puissance.

En simulation, le comportement du circuit équivalent de la figure 2 a été comparé à celui du résonateur formé uniquement des éléments C4, R8, et L2, et il a été observé qu'il n'y a pas de différence substantielle et que la position en fréquence du pic de résonance est représentative de la valeur du capteur R8 placé à l'intérieur de la cellule, avec un décalage acceptable (i.e. dont la valeur est inférieure à un seuil prédéterminé) vers les hautes fréquences. Plus précisément, un tel décalage acceptable vers les hautes fréquences signifie que l'impédance de l'accumulateur électrochimique correspondant à une cellule Li-ion générique, correctement isolée par les composants spécifiquement dédiés à cette fonction, influence de manière négligeable la réponse fréquentielle du capteur résistif R8, et la faisabilité d'introduire un capteur « résistif » à l'intérieur de l'accumulateur électrochimique et de l'interroger à fréquence fixe ou en utilisant une plage de fréquence d'excitation étroite, centrée sur ladite fréquence fixe prédéterminée, et définie à -3 dB de l'amplitude du pic de résonnance associée à ladite fréquence fixe prédéterminée, et ce en passant uniquement par ses bornes de puissance naturellement présentes.

Au vu de ce comportement, il est spécifiquement proposé selon la présente invention, via le module de mesure 26 de la figure 1 d'interroger ce capteur résistif R8 avec à fréquence fixe ou en utilisant une plage de fréquence d'excitation étroite, centrée sur ladite fréquence fixe prédéterminée et définie à -3 dB de l'amplitude du pic de résonnance associée à ladite fréquence fixe prédéterminée, en pilotant le générateur de tension V2 du circuit équivalent de la figure 2 sur fréquence fixe ou en utilisant une plage de fréquence d'excitation étroite, centrée sur ladite fréquence fixe prédéterminée et définie à -3 dB de l'amplitude du pic de résonnance associée à ladite fréquence fixe prédéterminée. Avantageusement, la forme du pic de résonance, en amplitude ou en facteur de qualité Q est, selon la présente invention, un indicateur de la température selon l'exemple de la figure 2 (ou de la grandeur physique interne en général pour d'autres types de capteur résistif tels que cités précédemment) dont la mesure est requise (i.e. souhaitée).

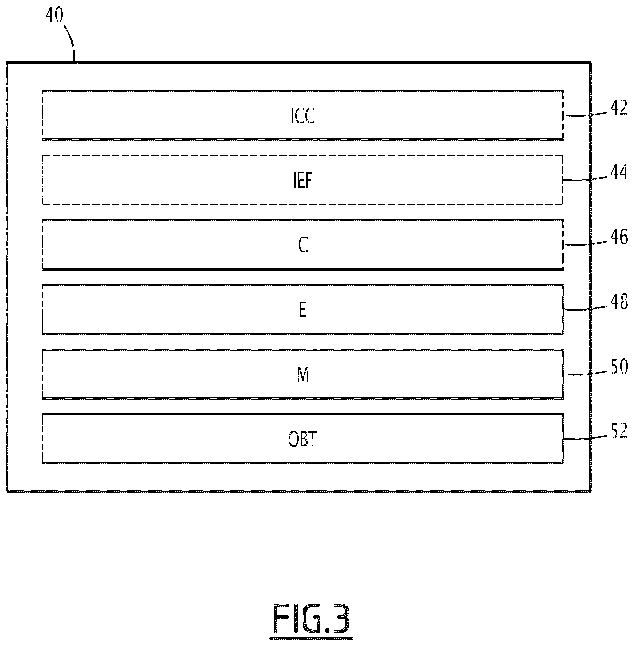

On décrit désormais ci-après, en relation avec la figure 3, un exemple de fonctionnement dudit système 10 de mesure physique.

Plus précisément, selon le mode de réalisation de la présente invention illustré par la figure 3, le procédé 40 de mesure physique au cœur d'un accumulateur électrochimique présentant deux bornes de puissance distinctes comprend une première étape 42 d'introduction ICC d'au moins un capteur résistif à l'intérieur dudit accumulateur électrochimique, ledit au moins un capteur résistif étant connecté via une de ses extrémités à une desdites deux bornes de puissance distinctes, l'autre extrémité dudit capteur résistif étant connectée, via un élément électrique de blocage de courant continu, à l'autre desdites deux bornes de puissance distinctes.

Optionnellement, tel que représenté en pointillés, notamment lorsque la deuxième variante précitée est mise en œuvre, le procédé 40 selon la présente invention comprend en outre une étape 44 d'introduction IEF à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

A noter que cette étape optionnelle 44 n'est pas mise en œuvre (i.e. n'a pas besoin d'être mise en œuvre) lorsque, tel que décrit précédemment, selon une première variante, ledit au moins un capteur résistif et chaque élément électrique dudit ensemble d'éléments électriques externes formant, avec ledit au moins un capteur résistif, au moins un circuit électrique résonant, présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique est maximale.

Avec ou sans l'option 44 précitée, le procédé 40 selon la présente invention comprend également une étape 46 de connexion C dudit ensemble d'éléments électriques externes audit accumulateur électrochimique, via chacune de ses deux extrémités à chacune desdites deux bornes de puissance distinctes, de sorte à former, avec ledit au moins un capteur résistif, au moins un circuit électrique résonant propre à résonner à une fréquence fixe prédéterminée.

Le procédé 40 selon la présente invention comprend en outre une étape 48 d'excitation E dudit au moins un circuit électrique résonant en pilotant une génération de tension d'alimentation, au niveau desdites deux bornes de puissance distinctes, sur au moins une plage de fréquence centrée sur ladite fréquence fixe prédéterminée.

Le procédé 40 selon la présente invention comprend également une étape 50 de mesure M d'au moins une information représentative de la forme du pic de résonnance résultant.

Le procédé 40 selon la présente invention comprend enfin une étape 52 d'obtention OBT d'une valeur d'au moins une grandeur physique interne dudit accumulateur électrochimique à partir de ladite au moins une information représentative mesurée.

L'homme du métier comprendra que l'invention ne se limite pas aux modes de réalisation décrits, ni aux exemples particulier de la description, les modes de réalisation et les variantes mentionnées ci-dessus étant propres à être combinés entre eux pour générer de nouveaux modes de réalisation de l'invention.

La présente invention, permet ainsi de fournir une mesure physique du coeur (i.e. de l'intérieur) d'un accumulateur électrochimique, via l'interrogation à fréquence fixe d'un résonateur RLC formé par ledit au moins un capteur résistif interne audit accumulateur électrochimique et un ensemble d'éléments électriques externes audit accumulateur électrochimique, ou en utilisant une plage de fréquence d'excitation étroite, centrée sur ladite fréquence fixe prédéterminée du résonateur RLC et définie à -3 dB de l'amplitude du pic de résonnance associée à ladite fréquence fixe prédéterminée, et permet avantageusement d'éviter l'ajout de borne(s) de puissance supplémentaire(s) dédiée(s) à la mesure et le coût associé.

Le fait de pouvoir interroger à distance ledit au moins un capteur résistif qui a un comportement passif, et sans connectiques additionnelles, constitue un avantage considérable du point de vue d'une possible industrialisation, car cela laisse libre le constructeur de choisir l'emplacement du circuit résonant selon ce qui est le plus avantageux pour lui.

## Revendications

1. Système (10) de mesure physique au coeur d'un accumulateur électrochimique (12) présentant deux bornes de puissance distinctes (16,18), **caractérisé en ce que** ledit système comprend au moins :
- au moins un capteur résistif (20) introduit à l'intérieur dudit accumulateur électrochimique, et connecté via une de ses extrémités à une desdites deux bornes de puissance distinctes, l'autre extrémité dudit capteur résistif étant connectée, via un élément (21) électrique de blocage de courant continu, à l'autre desdites deux bornes de puissance distinctes ;
- un ensemble (22) d'éléments électriques externes audit accumulateur électrochimique, ledit ensemble étant connecté via chacune de ses deux extrémités à chacune desdites deux bornes de puissance distinctes de sorte à former, avec ledit au moins un capteur résistif (20), au moins un circuit électrique résonant propre à résonner à une fréquence fixe prédéterminée ;
- un module de mesure (26), externe audit accumulateur électrochimique, configuré pour :
- exciter ledit au moins un circuit électrique résonant en pilotant une génération de tension d'alimentation, au niveau desdites deux bornes de puissance distinctes, sur au moins une plage de fréquence centrée sur ladite fréquence fixe prédéterminée;
- mesurer au moins une information représentative de la forme du pic de résonance résultant ;
- obtenir une valeur d'au moins une grandeur physique interne dudit accumulateur électrochimique à partir de ladite au moins une information représentative mesurée.

2. Système (10) de mesure physique selon la revendication 1, dans lequel ledit ensemble (22) d'éléments électriques externes audit accumulateur électrochimique (12) comprend au moins une inductance et au moins un condensateur de sorte à former en série avec ledit au moins un capteur résistif ledit au moins un circuit électrique résonant.

3. Système (10) de mesure physique selon la revendication 1 ou 2, dans lequel ladite au moins une information représentative appartient au groupe comprenant :
- une amplitude dudit pic de résonance résultant ;
- un facteur de qualité dudit pic de résonance résultant.

4. Système (10) de mesure physique selon l'une quelconque des revendications précédentes, dans lequel ledit au moins un capteur résistif (20) et chaque élément électrique dudit ensemble (22) d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique (12) est maximale.

5. Système (10) de mesure physique selon l'une quelconque des revendications précédentes 1 à 3, comprenant en outre, à l'intérieur dudit accumulateur électrochimique (12), un ensemble (28) d'éléments de filtrage limitant la perturbation due à l'impédance interne propre uniquement audit accumulateur électrochimique et/ou due à la présence d'au moins un équipement externe connecté audit accumulateur électrochimique (12).

6. Système (10) de mesure physique selon la revendication 5, dans lequel ledit ensemble (28) d'éléments de filtrage comprend quatre éléments inductifs insérés en série entre lesdites deux bornes de puissance distinctes dudit accumulateur électrochimique.

7. Système (10) de mesure physique selon la revendication 6, dans lequel la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système.

8. Système (10) de mesure physique selon l'une quelconque des revendications précédentes, dans lequel ledit système (10) comprend au moins deux capteurs résistifs distincts de sorte à former avec ledit ensemble d'éléments électriques externes audit accumulateur électrochimique au moins deux circuits électriques résonants distincts propres à résonner à au moins deux fréquences fixes prédéterminées distinctes, ledit module de mesure, externe audit accumulateur électrochimique, étant configuré pour :
- exciter ledit au moins un circuit électrique résonant en pilotant une génération de tension d'alimentation, au niveau desdites deux bornes de puissance distinctes, sur au moins deux plages de fréquence distinctes centrées respectivement sur lesdites au moins deux fréquences fixes prédéterminées distinctes;
- mesurer une information représentative de la forme de chaque pic de résonance résultant ;
- obtenir une valeur d'au moins une grandeur physique interne dudit accumulateur électrochimique à partir de chaque information représentative mesurée.

9. Système (10) de mesure physique selon l'une quelconque des revendications précédentes, dans lequel chaque plage de fréquence d'excitation est étroite et définie à -3 dB de l'amplitude du pic de résonance associée à chaque fréquence fixe prédéterminée.

10. Système (10) de mesure physique selon l'une quelconque des revendications précédentes 1 à 9, dans lequel ledit au moins un capteur résistif (20) est au moins un élément appartenant au groupe comprenant au moins :
- un ensemble comprenant au moins une résistance de type CTN à coefficient de température négatif ;
- un ensemble comprenant au moins une résistance de type CTP à coefficient de température positif ;
- une jauge de déformation ;
- un capteur de pression résistif.

11. Système (10) de mesure physique selon l'une quelconque des revendications précédentes, dans lequel ledit ensemble d'éléments électriques externes audit accumulateur électrochimique est déconnectable/reconnectable auxdites deux bornes de puissance distinctes.

12. Procédé (40) de mesure physique au coeur d'un accumulateur électrochimique présentant deux bornes de puissance distinctes, comprenant au moins les étapes suivantes :
- introduction (42) d'au moins un capteur résistif à l'intérieur dudit accumulateur électrochimique, ledit au moins un capteur résistif étant connecté via une de ses extrémités à une desdites deux bornes de puissance distinctes, l'autre extrémité dudit capteur résistif étant connectée, via un élément électrique de blocage de courant continu, à l'autre desdites deux bornes de puissance distinctes ;
- connexion (46) d'un ensemble d'éléments électriques externes audit accumulateur électrochimique, via chacune de ses deux extrémités à chacune desdites deux bornes de puissance distinctes, de sorte à former, avec ledit au moins un capteur résistif, au moins un circuit électrique résonant propre à résonner à une fréquence fixe prédéterminée;
- excitation (48) dudit au moins un circuit électrique résonant en pilotant une génération de tension d'alimentation, au niveau desdites deux bornes de puissance distinctes, sur au moins une plage de fréquence centrée sur ladite fréquence fixe prédéterminée;
- mesure (50) d'au moins une information représentative de la forme du pic de résonance résultant ;
- obtention (52) d'une valeur d'au moins une grandeur physique interne dudit accumulateur électrochimique à partir de ladite au moins une information représentative mesurée.

13. Procédé (40) de mesure physique selon la revendication 12, comprenant en outre l'introduction (44) à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

## Patentansprüche

1. System (10) zur physikalischen Messung im Inneren eines elektrochemischen Akkumulators (12), der zwei separate Leistungsanschlüsse (16,18) aufweist, **dadurch gekennzeichnet, dass** das genannte System mindestens Folgendes umfasst:
- mindestens einen resistiven Sensor (20), der in das Innere des genannten elektrochemischen Akkumulators eingeführt und über eines seiner Enden mit einem der genannten zwei separaten Leistungsanschlüsse verbunden ist, wobei das andere Ende des genannten resistiven Sensors über ein elektrisches Element (21) zur Gleichstromsperrung mit dem anderen der genannten zwei separaten Leistungsanschlüsse verbunden ist;
- eine Anordnung (22) elektrischer Bauelemente, die außerhalb des genannten elektrochemischen Akkumulators angeordnet sind, wobei die genannte Anordnung über jedes ihrer zwei Enden mit jeweils einem der genannten zwei separaten Leistungsanschlüsse verbunden ist, um mit dem genannten mindestens einen resistiven Sensor (20) mindestens einen elektrischen Resonanzkreis zu bilden, der geeignet ist, bei einer vorbestimmten festen Frequenz in Resonanz zu treten;
- ein Messmodul (26), das außerhalb des genannten elektrochemischen Akkumulators angeordnet und konfiguriert ist, um:
- den genannten mindestens einen elektrischen Resonanzkreis anzuregen, indem es eine Erzeugung einer Versorgungsspannung an den genannten zwei separaten Leistungsanschlüssen über mindestens einen Frequenzbereich steuert, der auf die genannte vorbestimmte feste Frequenz zentriert ist;
- mindestens eine für die Form der resultierenden Resonanzspitze repräsentative Information zu messen;
- einen Wert mindestens einer internen physikalischen Größe des genannten elektrochemischen Akkumulators aus der genannten mindestens einen gemessenen repräsentativen Information zu erhalten.

2. System (10) zur physikalischen Messung nach Anspruch 1, wobei die genannte Anordnung (22) elektrischer Bauelemente, die außerhalb des genannten elektrochemischen Akkumulators (12) angeordnet sind, mindestens eine Induktivität und mindestens einen Kondensator umfasst, um in Reihe mit dem genannten mindestens einen resistiven Sensor den genannten mindestens einen elektrischen Resonanzkreis zu bilden.

3. System (10) zur physikalischen Messung nach Anspruch 1 oder 2, wobei die genannte mindestens eine repräsentative Information zu der Gruppe gehört, die Folgendes umfasst:
- eine Amplitude der genannten resultierenden Resonanzspitze,
- einen Gütefaktor der genannten resultierenden Resonanzspitze.

4. System (10) zur physikalischen Messung nach einem beliebigen der vorhergehenden Patentansprüche, wobei der genannte mindestens eine resistive Sensor (20) und jedes elektrische Bauelement der genannten Anordnung (22) elektrischer Bauelemente zuvor bestimmte Werte aufweisen, sodass die Resonanzfrequenz des genannten mindestens einen resultierenden elektrischen Resonanzkreises in einem dritten Frequenzbereich liegt, in dem die ausschließlich dem genannten elektrochemischen Akkumulator (12) eigene interne Impedanz maximal ist.

5. System (10) zur physikalischen Messung nach einem beliebigen der vorhergehenden Patentansprüche 1 bis 3, ferner umfassend, im Inneren des genannten elektrochemischen Akkumulators (12), eine Anordnung (28) von Filterelementen, die die Störung aufgrund der ausschließlich dem genannten elektrochemischen Akkumulator eigenen internen Impedanz und/oder aufgrund des Vorhandenseins mindestens einer externen Einrichtung, die mit dem genannten elektrochemischen Akkumulator (12) verbunden ist, begrenzt.

6. System (10) zur physikalischen Messung nach Anspruch 5, wobei die genannte Anordnung (28) von Filterelementen vier induktive Elemente umfasst, die in Reihe zwischen die genannten zwei separaten Leistungsanschlüsse des genannten elektrochemischen Akkumulators eingefügt sind.

7. System (10) zur physikalischen Messung nach Anspruch 6, wobei der Wert jedes der genannten induktiven Filterelemente derart definiert ist, dass die Dynamik, die dem Verhältnis des genannten Werts zu der ausschließlich dem genannten elektrochemischen Akkumulator eigenen internen Impedanz entspricht, zehnmal geringer ist als die anfängliche Dynamik des genannten elektrochemischen Akkumulators, der von dem genannten System getrennt ist.

8. System (10) zur physikalischen Messung nach einem beliebigen der vorhergehenden Patentansprüche, wobei das genannte System (10) mindestens zwei verschiedene resistive Sensoren umfasst, um mit der genannten Anordnung elektrischer Bauelemente, die außerhalb des genannten elektrochemischen Akkumulators angeordnet sind, mindestens zwei verschiedene elektrische Resonanzkreise zu bilden, die geeignet sind, bei mindestens zwei verschiedenen vorbestimmten festen Frequenzen in Resonanz zu treten, wobei das genannte Messmodul, das außerhalb des genannten elektrochemischen Akkumulators angeordnet ist, konfiguriert ist, um:
- den genannten mindestens einen elektrischen Resonanzkreis anzuregen, indem es eine Erzeugung einer Versorgungsspannung an den genannten zwei separaten Leistungsanschlüssen über mindestens zwei verschiedene Frequenzbereiche steuert, die jeweils auf die genannten mindestens zwei verschiedenen vorbestimmten festen Frequenzen zentriert sind;
- eine für die Form jeder resultierenden Resonanzspitze repräsentative Information zu messen;
- einen Wert mindestens einer internen physikalischen Größe des genannten elektrochemischen Akkumulators aus jeder gemessenen repräsentativen Information zu erhalten.

9. System (10) zur physikalischen Messung nach einem beliebigen der vorhergehenden Patentansprüche, wobei jeder Anregungsfrequenzbereich schmal und bei -3 dB der Amplitude der jeder vorbestimmten festen Frequenz zugeordneten Resonanzspitze definiert ist.

10. System (10) zur physikalischen Messung nach einem beliebigen der vorhergehenden Patentansprüche 1 bis 9, wobei der genannte mindestens eine resistive Sensor (20) mindestens ein Element ist, das zu der Gruppe gehört, die mindestens Folgendes umfasst:
- eine Anordnung, die mindestens einen Widerstand des Typs NTC mit negativem Temperaturkoeffizienten umfasst;
- eine Anordnung, die mindestens einen Widerstand des Typs PTC mit positivem Temperaturkoeffizienten umfasst;
- einen Dehnungsmessstreifen;
- einen resistiven Drucksensor.

11. System (10) zur physikalischen Messung nach einem beliebigen der vorhergehenden Patentansprüche, wobei die genannte Anordnung elektrischer Bauelemente, die außerhalb des genannten elektrochemischen Akkumulators angeordnet sind, von den genannten zwei separaten Leistungsanschlüssen trennbar/wieder mit ihnen verbindbar ist.

12. Verfahren (40) zur physikalischen Messung im Inneren eines elektrochemischen Akkumulators, der zwei separate Leistungsanschlüsse aufweist, umfassend mindestens die folgenden Schritte:
- Einführen (42) mindestens eines resistiven Sensors in das Innere des genannten elektrochemischen Akkumulators, wobei der genannte mindestens eine resistive Sensor über eines seiner Enden mit einem der genannten zwei separaten Leistungsanschlüsse verbunden ist, wobei das andere Ende des genannten resistiven Sensors über ein elektrisches Element zur Gleichstromsperrung mit dem anderen der genannten zwei separaten Leistungsanschlüsse verbunden ist;
- Verbinden (46) einer Anordnung elektrischer Bauelemente, die außerhalb des genannten elektrochemischen Akkumulators angeordnet sind, über jedes ihrer zwei Enden mit jeweils einem der genannten zwei separaten Leistungsanschlüsse, um mit dem genannten mindestens einen resistiven Sensor mindestens einen elektrischen Resonanzkreis zu bilden, der geeignet ist, bei einer vorbestimmten festen Frequenz in Resonanz zu treten;
- Anregen (48) des genannten mindestens einen elektrischen Resonanzkreises durch Steuern einer Erzeugung einer Versorgungsspannung an den genannten zwei separaten Leistungsanschlüssen über mindestens einen Frequenzbereich, der auf die genannte vorbestimmte feste Frequenz zentriert ist;
- Messen (50) mindestens einer für die Form der resultierenden Resonanzspitze repräsentativen Information;
- Ermittlung (52) eines Werts mindestens einer internen physikalischen Größe des genannten elektrochemischen Akkumulators anhand der genannten mindestens einen gemessenen repräsentativen Information.

13. Verfahren (40) zur physikalischen Messung nach Anspruch 12, ferner umfassend das Einführen (44) einer Anordnung von Filterelementen in das Innere des genannten elektrochemischen Akkumulators, welche die Störung begrenzt, die auf die ausschließlich dem genannten elektrochemischen Akkumulator eigene interne Impedanz und/oder auf das Vorhandensein mindestens einer mit dem genannten elektrochemischen Akkumulator verbundenen externen Einrichtung zurückzuführen ist.

## Claims

1. Physical measurement system (10) at the core of an electrochemical accumulator (12) having two separate power terminals (16,18), **characterized in that** said system comprises at least:
- at least one resistive sensor (20) introduced inside said electrochemical accumulator, and connected via one of its ends to one of said two separate power terminals, the other end of said resistive sensor being connected, via an electrical direct-current blocking element (21), to the other of said two separate power terminals;
- a set (22) of electrical elements external to said electrochemical accumulator, said set being connected via each of its two ends to each of said two separate power terminals so as to form, with said at least one resistive sensor (20), at least one resonant electrical circuit capable of resonating at a predetermined fixed frequency;
- a measurement module (26), external to said electrochemical accumulator, configured to:
- excite said at least one resonant electrical circuit by controlling a generation of supply voltage, at said two separate power terminals, over at least one frequency range centered on said predetermined fixed frequency;
- measure at least one item of representative information on the shape of the resulting resonance peak;
- obtain a value of at least one internal physical quantity of said electrochemical accumulator from said at least one measured item of representative information.

2. Physical measurement system (10) according to claim 1, wherein said set (22) of electrical elements external to said electrochemical accumulator (12) comprises at least one inductor and at least one capacitor so as to form in series with said at least one resistive sensor said at least one resonant electrical circuit.

3. Physical measurement system (10) according to claim 1 or 2, wherein said at least one item of representative information belongs to the group comprising:
- an amplitude of said resulting resonance peak,
- a quality factor of said resulting resonance peak.

4. Physical measurement system (10) according to any one of the preceding claims, wherein said at least one resistive sensor (20) and each electrical element of said set (22) of electrical elements have predetermined values so that the resonance frequency of said at least one resulting resonant electrical circuit belongs to a third frequency range in which the internal impedance specific solely to said electrochemical accumulator (12) is maximal.

5. Physical measurement system (10) according to any one of preceding claims 1 to 3, further comprising, inside said electrochemical accumulator (12), a set (28) of filtering elements limiting the disturbance due to the internal impedance specific solely to said electrochemical accumulator and/or due to the presence of at least one external device connected to said electrochemical accumulator (12).

6. Physical measurement system (10) according to claim 5, wherein said set (28) of filtering elements comprises four inductive elements inserted in series between said two separate power terminals of said electrochemical accumulator.

7. Physical measurement system (10) according to claim 6, wherein the value of each of said inductive filtering elements is defined such that the dynamic range corresponding to the ratio of said value to said internal impedance specific solely to said electrochemical accumulator is ten times lower than the initial dynamic range of said electrochemical accumulator disconnected from said system.

8. Physical measurement system (10) according to any one of the preceding claims, wherein said system (10) comprises at least two distinct resistive sensors so as to form with said set of electrical elements external to said electrochemical accumulator at least two distinct resonant electrical circuits capable of resonating at at least two distinct predetermined fixed frequencies, said measurement module, external to said electrochemical accumulator, being configured to:
- excite said at least one resonant electrical circuit by controlling a generation of supply voltage, at said two separate power terminals, over at least two distinct frequency ranges centered respectively on said at least two distinct predetermined fixed frequencies;
- measure an item of representative information on the shape of each resulting resonance peak;
- obtain a value of at least one internal physical quantity of said electrochemical accumulator from each measured item of representative information.

9. Physical measurement system (10) according to any one of the preceding claims, wherein each excitation frequency range is narrow and defined at -3 dB of the amplitude of the resonance peak associated with each predetermined fixed frequency.

10. Physical measurement system (10) according to any one of preceding claims 1 to 9, wherein said at least one resistive sensor (20) is at least one element belonging to the group comprising at least:
- a set comprising at least one NTC-type resistor with a negative temperature coefficient;
- a set comprising at least one PTC-type resistor with a positive temperature coefficient;
- a strain gauge;
- a resistive pressure sensor.

11. Physical measurement system (10) according to any one of the preceding claims, wherein said set of electrical elements external to said electrochemical accumulator is disconnectable/reconnectable to said two separate power terminals.

12. Method (40) for physical measurement at the core of an electrochemical accumulator having two separate power terminals, comprising at least the following steps:
- introduction (42) of at least one resistive sensor inside said electrochemical accumulator, said at least one resistive sensor being connected via one of its ends to one of said two separate power terminals, the other end of said resistive sensor being connected, via an electrical direct-current blocking element, to the other of said two separate power terminals;
- connection (46) of a set of electrical elements external to said electrochemical accumulator, via each of its two ends to each of said two separate power terminals, so as to form, with said at least one resistive sensor, at least one resonant electrical circuit capable of resonating at a predetermined fixed frequency;
- excitation (48) of said at least one resonant electrical circuit by controlling a generation of supply voltage, at said two separate power terminals, over at least one frequency range centered on said predetermined fixed frequency;
- measurement (50) of at least one item of representative information on the shape of the resulting resonance peak;
- obtaining (52) a value of at least one internal physical quantity of said electrochemical accumulator from said at least one measured representative information.

13. Physical measurement method (40) according to claim 12, further comprising introducing (44), inside said electrochemical accumulator, a set of filtering elements limiting the disturbance due to the internal impedance specific solely to said electrochemical accumulator and/or due to the presence of at least one external device connected to said electrochemical accumulator.
